# EUROPÄISCHE PATENTSCHRIFT

(11) **EP 3 384 527 B1**
(45) Veröffentlichungstag und Bekanntmachung des Hinweises auf die Patenterteilung: **01.01.2020**
(21) Anmeldenummer: 16802020.4
(22) Anmeldetag: 24.11.2016
(51) Int. Cl.: H01L 23/373

(54) **ELEKTRONISCHES LEISTUNGSMODUL**
ELECTRONIC POWER MODULE
MODULE ÉLECTRONIQUE DE PUISSANCE

(30) Priorität: 04.12.2015 DE 102015015699
(43) Veröffentlichungstag der Anmeldung: 10.10.2018
(73) Patentinhaber: Audi AG, 85045 Ingolstadt (DE); ABB Schweiz AG, 5400 Baden (CH)
(72) Erfinder: APELSMEIER, Andreas, 85131 Pollenfeld (DE); VETTER, Günter, 72393 Burladingen (DE)
(86) Internationale Anmeldenummer: PCT/EP2016/078680
(87) Internationale Veröffentlichungsnummer: WO 2017/093116

(56) Entgegenhaltungen:
- EP-A1- 1 189 277
- DE-A1- 2 945 385
- DE-A1-102004 019 445
- US-A- 5 948 689
- US-A1- 2013 119 404
- US-A1- 2014 290 926
- US-A1- 2015 311 137

## Beschreibung

Die Erfindung betrifft ein elektronisches Leistungsmodul, umfassend wenigstens ein Halbleiterbauelement, das auf einem Träger angeordnet ist, sowie einen Kühlkörper, der in thermischem Kontakt mit dem Halbleiterbauelement steht.

Solche elektronischen Leistungsmodule kommen in unterschiedlichen Anwendungsbereichen zum Einsatz. Ein Beispiel sind Anwendungen im Kraftfahrzeug, wo sie im Betrieb über das üblicherweise auf 12 V ausgelegte Bordnetz beispielsweise im Bereich der Lenkungs- oder Getriebesteuerung verwendet werden. Weitere Anwendungen sind bei Hybridfahrzeugen oder Plug-in-Hybridfahrzeugen gegeben, wo solche Halbleiter-Leistungsmodule z. B. im Traktionspulswechselrichter oder im DC/DC-Wandler zum Einsatz kommen.

Ein solches Leistungsmodul ist in seiner Herstellung und seinem Aufbau relativ aufwändig. In einem ersten Schritt wird ein Träger, ein sogenanntes DCB-Substrat (DCB = Direct Copper Bonded) hergestellt. Substrate für Leistungshalbleitermodule sind beispielsweise in der EP1189277 beschrieben. Hierzu wird zumeist ein Keramiksubstrat, üblicherweise Al₂O₃-Keramik, beidseitig über einen Bondprozess mit Kupfer belegt, so dass sich beidseits großflächige Kupferebenen ergeben. In einem nächsten Schritt muss an einer Seite, an der das oder die elektronischen Bauelemente anzuordnen sind, ein entsprechendes Schaltungslayout strukturiert werden, üblicherweise in einem Maskierungs- und nachfolgenden Abtragprozess. Sodann wird das oder werden die Halbleiterbauelemente, üblicherweise in Chipform, über einen Sinter- oder Lötprozess auf der strukturierten Kupferschicht, also der Metallschicht, befestigt und kontaktiert. Sodann werden in einem weiteren Prozessschritt das oder die Bauelemente an ihrer Oberseite entsprechend durch Löten, Bonden oder Sintern untereinander oder mit der Metallstruktur kontaktiert. Schließlich wird in einem letzten Schritt der derart hergestellte Aufbau über einen großflächigen Lötprozess an der gegenüberliegenden Kupferschicht ein Kühlkörper befestigt, der beispielsweise aus Kupfer, AlSiCu oder dergleichen hergestellt ist. Der Herstellprozess erfordert also eine Vielzahl von unterschiedlichen Schritten und insbesondere das aufwändige Herstellen und Hantieren des DCB-Substrats.

Der Erfindung liegt damit das Problem zugrunde, ein demgegenüber einfach aufgebautes Leistungsmodul anzugeben.

Zur Lösung dieses Problems ist bei einem elektronischen Leistungsmodul der eingangs genannten Art erfindungsgemäß vorgesehen, dass der Träger aus einem Halbleitermaterial, dass an dem Träger durch entsprechende Dotierung eine leitfähige Struktur ausgebildet ist, mit der das wenigstens eine darauf angeordnete Halbleiterbauelement kontaktiert ist, und dass der Träger zugleich als Kühlkörper dient.

Bei dem erfindungsgemäßen Leistungsmodul kommt dem Träger eine Doppelfunktion zu. Einerseits dient er als Substrat, an dem das oder die Halbleiterbauelemente angeordnet werden, andererseits dient er gleichzeitig als Kühlkörper. Es kommt also lediglich ein Bauteil zum Einsatz, das der Bestückung und Kühlung dient, anders als im Stand der Technik, wo wie beschrieben in aufwändiger Weise ein DCB-Substrat als zu bestückendes Trägerteil herzustellen ist, sowie ein separater zusätzlicher Kühlkörper. Da das oder die Halbleiterbauelemente direkt auf dem Halbleiter-Träger aufgebaut werden, ergeben sich des Weiteren Vorteile hinsichtlich der Lebensdauer des Leistungsmoduls, da weniger unterschiedliche Materialien innerhalb des Gesamtaufbaus gegeben sind, so dass es zu deutlich geringeren thermomechanischen Spannungen im Betrieb kommt. Wie beschrieben ist im Stand der Technik das DCB-Substrat bestehend aus dem Keramikträger sowie den beidseitigen Kupferschichten vorgesehen, die wiederum unterschiedliche Ausdehnungskoeffizienten verglichen mit den zu verwendenden Kontaktmitteln wie dem Lot etc. sowie insbesondere dem Kühlkörper haben. Aufgrund des Entfalls des DCB-Substrats sind demzufolge weniger Ebenen respektive Schichten mit unterschiedlichen Wärmeausdehnungskoeffizienten gegeben, wie sich auch die Wärmeausdehnungskoeffizienten besser aufeinander abstimmen lassen. Auch kann der thermische Widerstand des Gesamtaufbaus optimiert werden, da wie beschrieben weniger Schichten aus unterschiedlichen Materialien zum Einsatz kommen.

Als Halbleitermaterial, aus dem der Träger besteht, wird bevorzugt Silizium verwendet, das in der Halbleitertechnik umfangreich verwendet wird und das prozesstechnisch seit langem problemlos bearbeitet werden kann. Aber auch andere Halbleitermaterialien wie beispielsweise GaN oder GaAs können als Halbleitermaterial verwendet werden.

Gemäß einer alternativen, nicht zur Erfindung gehörigen Ausführungsform kann auf dem Träger wenigstens eine Isolationsschicht aufgebracht werden, auf welcher wenigstens eine leitfähige Metallschicht aufgebracht ist, mit der das wenigstens eine Halbleiterbauelement kontaktiert ist. Der Träger wird also mit einer Isolationsschicht versehen, um ihn elektrisch von dem oder den Halbleiterbauelementen zu trennen. Auf die Isolationsschicht wird sodann eine leitfähige Metallschicht aufgebracht und strukturiert, die der Kontaktierung des oder der Halbleiterbauelemente dient.

Als Isolationsschicht wird besonders bevorzugt eine Oxidschicht verwendet, die unmittelbar auf dem Kühlkörper aus dem Halbleitermaterial erzeugt ist. Da bevorzugt Silizium verwendet wird, handelt es sich bei der Oxidschicht zweckmäßigerweise um eine SiO₂-Schicht, deren Herstellung ein gängiger Prozess in der Halbleitertechnik ist. Über diese Isolationsschicht kann insbesondere für Anwendungen im Hochvoltbereich, wenn also Spannungen von mehreren einhundert Volt anliegen, die Isolation des Trägers gegenüber dem aktiven Halbleiterbauelement erreicht werden.

Selbstverständlich ist es möglich, mehrere Halbleiterbauelemente auf der Metallschicht, die wie beschrieben entsprechend strukturiert ist, anzuordnen und mit dieser oder untereinander zu kontaktieren, so dass das Leistungsmodul letztlich beliebig konfiguriert werden kann.

Erfindungsgemäss ist am Träger selbst durch entsprechende Dotierung eine leitfähige Struktur ausgebildet, mit der das wenigstens eine elektronische Bauelement kontaktiert ist. Dabei wird also die leitfähige Struktur im Träger selbst durch Einbringen entsprechender Dotierungselemente erzeugt, das heißt, dass der Träger lokal hinreichend leitfähig ausgerüstet wird. Das oder die Halbleiterbauelemente werden in diesem Fall direkt auf den Träger ohne Zwischenschaltung einer Isolations- oder Metallschicht aufgesetzt und mit der leitfähigen Struktur entsprechend kontaktiert. Auch hier besteht die Möglichkeit, mehrere Halbleiterbauelemente mit der leitfähigen Struktur zu kontaktieren.

Zur Verbindung des oder der Halbleiterbauelemente der Metallschicht oder dem Träger selbst kommt ein Sinter- oder Lötprozess unter Verwendung entsprechender Sinter- oder Lötmaterialien zum Einsatz. Die Kontaktierung des oder der Halbleiterbauelemente an der Oberseite der Bauelemente kann durch Löten, Bonden oder Sintern erfolgen.

Als Halbleiterbauelement kann quasi jedes beliebige Halbleiterbauelement, das zur Strukturierung eines Leistungsmoduls benötigt oder erforderlich ist, verwendet werden, beispielsweise ein IGBT oder ein Dioden Bare Die, wobei diese Aufzählung nicht abschließend ist.

Wie beschrieben dient der Träger gleichzeitig auch als Kühlkörper. Um eine möglichst effiziente Wärmeabfuhr zu ermöglichen ist der Kühlkörper gemäß einer Weiterbildung der Erfindung zur Bildung einer Kühlstruktur rückseitig strukturiert. Die Kühlstruktur wird bevorzugt in Form von Stegen oder Rippen erzeugt, so dass sich über diese Strukturierung eine deutlich vergrößerte Oberfläche erzeugen lässt, über die die Wärmeabfuhr erfolgt.

Ein bemerkenswerter weiterer Vorteil der Erfindung besteht ferner darin, dass es infolge der Verwendung eines Trägers aus einem Halbleitermaterial möglich ist, im Träger selbst durch Dotierung wenigstens ein weiteres elektronisches Bauelement auszubilden, also im Träger direkt zu integrieren. Das heißt, dass durch Einbringen entsprechender Dotierelemente entsprechende Bauteile wie Strom- oder Temperatursensoren, Dioden und dergleichen ausgebildet werden können. In diesem Fall kommt dem Träger also noch eine dritte Funktion neben der Aufnahme der Halbleiterbauelemente und der Kühlung zu, nämlich als Substrat für die integrierte Ausbildung eines oder mehrerer weiterer elektronischer Bauelemente.

Weitere Vorteile und Einzelheiten der Erfindung ergeben sich aus den im Folgenden beschriebenen Ausführungsbeispielen sowie anhand der Zeichnung. Dabei zeigen:
- Fig. 1: eine Prinzipdarstellung eines elektronischen Leistungsmoduls einer ersten die nicht zur Erfindung gehört,
- Fig. 2: eine Prinzipdarstellung eines elektronischen Leistungsmoduls einer zweiten Ausführungsform, die nicht zur Erfindung gehört, und
- Fig. 3: eine Prinzipdarstellung eines elektronischen Leistungsmoduls einer erfindungsgemäßen Ausführungsform.

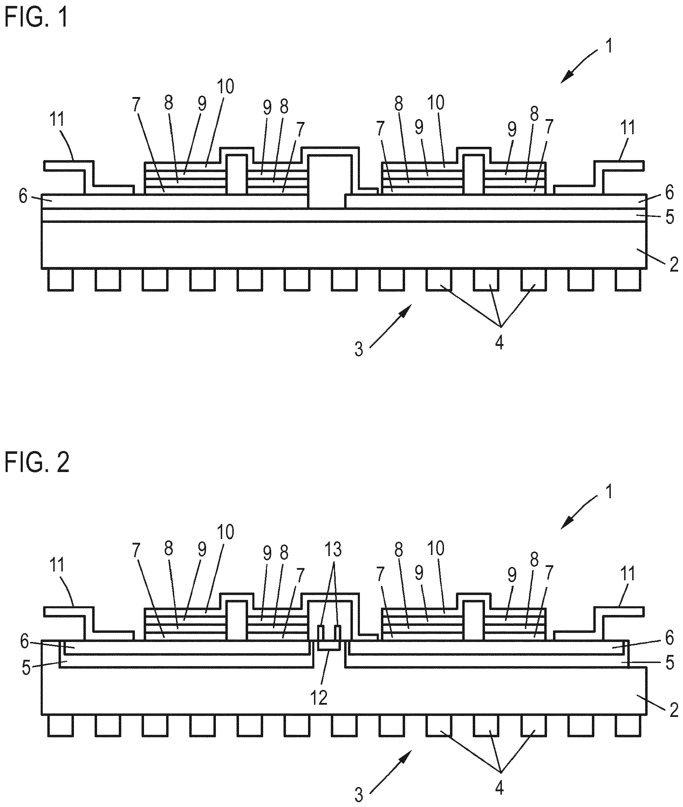

Fig. 1 zeigt ein elektronisches Leistungsmodul 1, umfassend einen Träger 2 aus einem Halbleitermaterial, beispielsweise Silizium. Dieser Träger 2 dient als Substrat zur Aufnahme von Bauelementen und gleichzeitig als Kühlkörper. Er ist an seiner Unterseite mit einer Oberflächenstrukturierung 3 versehen, hier in Form von hervorspringenden Rippen oder Stegen 4.

Auf dem multifunktionalen, weil auch als Kühlkörper fungierenden Träger 2 ist eine Isolationsschicht 5 aufgebracht, die hier beispielsweise als ganzflächig erzeugte Oxidschicht, bei einem Halbleiterträger 2 aus Silizium folglich eine SiO₂-Schicht, ausgeführt ist. Auf der Isolationsschicht 5 ist weiterhin eine z. B. durch Maskierung und Ätzen strukturierte weitere Metallschicht aufgebracht, beispielsweise aus Cu oder Al. Mit dieser Metallschicht sind über entsprechende Verbindungsschichten 7, beispielsweise Lötschichten oder Sinterschichten, mehrere Halbleiterbauelemente 8 kontaktiert. Bei diesen Halbleiterbauelementen 8 handelt es sich beispielsweise um IGBTs oder Dioden Bare Dies. Über eine weitere Verbindungsschicht 9, wiederum beispielsweise eine Löt- oder Sinterschicht, sind entsprechende Verbindungsleitungen 10, bei denen es sich um eine Kupfer- oder Silberfolie handeln kann, mit den Halbleiterbauelementen 8 kontaktiert, welche Verbindungsleitungen 10 je nach vorgegebener Schaltung entsprechend geführt sind. So ist beispielsweise die links gezeigte Verbindungsleitung 10 mit der rechts gezeigten Metallschicht 6 verbunden.

Schließlich sind entsprechende Anschlüsse 11 an der Metallschicht 6 vorgesehen, mit denen das Leistungsmodul 1 entsprechend verschaltet werden kann.

Ersichtlich ist der Aufbau des Leistungsmoduls 1 relativ einfach, insbesondere da kein separates DCB-Substrat herzustellen ist, das als Träger für die Halbleiterbauelemente dient, und an dem zusätzlich noch ein Kühlkörper anzuordnen ist. Vielmehr fungiert hier wie beschrieben der Träger 2 aus Halbleitermaterial einerseits als Aufbausubstrat für die eigentliche Schaltung respektive die Halbleiterbauelemente, zum anderen dient er gleichzeitig als Kühlkörper.

Fig. 2 zeigt eine weitere Ausführungsform eines elektronischen Leistungsmoduls 1, wobei für gleiche Bauteile gleiche Bezugszeichen verwendet werden.

Vorgesehen ist hier wiederum der Träger 2, der zugleich auch Kühlkörper ist und der rückseitig mit einer Oberflächenstrukturierung 3 mit Stegen 4 oder Rippen versehen ist.

Vorgesehen ist wiederum eine Isolationsschicht 5, wobei diese hier jedoch strukturiert ist, sie ist also nicht großflächig oder über die gesamte Trägerfläche abgeschieden, sondern nur lokal erzeugt. Handelt es sich bei dem Halbleitermaterial des Trägers 2 um Silizium, so ist die Isolationsschicht 5 aus SiO₂.

Jede der separaten Isolationsschichten 5 ist wiederum mit einer Metallschicht 6 belegt, auf der über entsprechende Verbindungsschichten 7 wiederum die Halbleiterbauelemente 8 angeordnet respektive kontaktiert sind. Über weitere Verbindungsschichten 9 sind die entsprechenden Verbindungsleitungen 10 mit den Halbleiterbauelementen 8 respektive den Metallschichten 6 etc. kontaktiert. Ebenfalls vorgesehen sind entsprechende Anschlüsse 11 für die Verschaltung des Leistungsmoduls 1.

Wie Fig. 2 zeigt ist im Bereich zwischen den beiden Isolationsschichten 5 ein weiteres elektronisches Bauelement 12, beispielsweise ein integrierter pn-Übergang beispielsweise für eine Temperatur- oder Strommessung, ausgebildet. Dieser pn-Übergang kann durch entsprechende Dotierung erzeugt werden. An ihm sind entsprechende Anschlüsse 13 ausgebildet, um ihn entsprechend verschalten zu können. Das heißt, dass dieses weitere elektronische Bauelement unmittelbar im Halbleiterträger 2 ausgebildet respektive erzeugt ist.

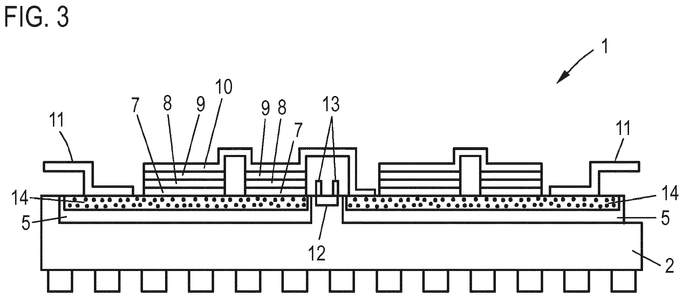

Fig. 3 zeigt schließlich ein erfindungsgemäßes elektronisches Leistungsmodul 1, dessen Aufbau dem aus Fig. 2 entspricht. Neben dem als Kühlkörper fungierten Träger 2 sind auch hier zwei separate, lokale respektive strukturierte Isolationsschichten 5 vorgesehen. Diese sind hier jedoch mit einer durch Dotierung leitfähig gemachten Strukturen 14 versehen respektive ist eine solche Struktur 14 an ihnen ausgebildet. Es ist also, anders als bei der Ausgestaltung nach Fig. 2, keine separate Metallschicht respektive Metallisierung aus Cu oder Al vorgesehen, sondern eine allein durch Dotierung erzeugte Leitfähigkeit an den Isolationsschichten 5 realisiert.

Diese leitfähigen Strukturen 14 dienen wiederum der Aufnahme respektive Kontaktierung der entsprechenden Halbleiterbauelemente 8 über die Verbindungsschichten 7 wie auch der Kontaktierung der Verbindungsleitungen 10 respektive der Anschlüsse 11. Vorgesehen ist auch hier exemplarisch ein am Träger 2 selbst durch Dotierung ausgebildetes elektronisches Bauelement 12, wie bei der Ausführung gemäß Fig. 2 bereits beschrieben. Bei diesem kann es sich wie beschrieben um einen Temperatursensor, aber auch einen Stromsensor, eine Diode oder dergleichen handeln.

## Patentansprüche

1. Elektronisches Leistungsmodul, umfassend wenigstens ein Halbleiterbauelement, das auf einem Träger angeordnet ist, sowie einen Kühlkörper, der in thermischem Kontakt mit dem Halbleiterbauelement steht, wobei der Träger (2) aus einem Halbleitermaterial besteht und zugleich als Kühlkörper dient,
**dadurch gekennzeichnet,**
**dass** am Träger (2) selbst durch Dotierung eine leitfähige Struktur (14) ausgebildet ist, mit der das wenigstens eine elektronische Halbleiterbauelement (8) kontaktiert ist

2. Elektronisches Leistungsmodul nach Anspruch 1,
**dadurch gekennzeichnet,**
**dass** das Halbleitermaterial Silizium ist.

3. Elektronisches Leistungsmodul nach Anspruch 1 oder 2,
**dadurch gekennzeichnet,**
**dass** mehrere Halbleiterbauelemente (8) mit der leitfähigen Struktur (14) kontaktiert sind.

4. Elektronisches Leistungsmodul nach einem der vorangehenden Ansprüche,
**dadurch gekennzeichnet,**
**dass** der Träger (8) zur Bildung einer Kühlstruktur rückseitig oberflächlich strukturiert ist.

5. Elektronisches Leistungsmodul nach Anspruch 4,
**dadurch gekennzeichnet,**
**dass** die Kühlstruktur in Form von Stegen (4) oder Rippen erzeugt ist.

6. Elektronisches Leistungsmodul nach einem der vorangehenden Ansprüche,
**dadurch gekennzeichnet,**
**dass** im Träger (2) durch Dotierung wenigstens ein weiteres elektronisches Bauelement (12) ausgebildet ist.

## Claims

1. Electronic power module including at least one semiconductor component which is disposed on a carrier, and a cooling body which is in thermal contact with the semiconductor component, wherein the carrier (2) consists of a semiconductor material and at the same time serves as a cooling body,
**characterised in**
**that** on the carrier (2) itself a conductive structure (14), with which the at least one electronic semiconductor component (8) is contacted, is formed by doping.

2. Electronic power module according to claim 1,
**characterised in**
**that** the semiconductor material is silicon.

3. Electronic power module according to claim 1 or 2,
**characterised in**
**that** several semiconductor components (8) are contacted with the conductive structure (14).

4. Electronic power module according to any of the preceding claims,
**characterised in**
**that** the carrier (8) is structured on its rear surface to form a cooling structure.

5. Electronic power module according to claim 4,
**characterised in**
**that** the cooling structure is generated in the form of webs (4) or ribs.

6. Electronic power module according to any of the preceding claims,
**characterised in**
**that** in the carrier (2) at least one further electronic component (12) is formed by doping.

## Revendications

1. Module de puissance électronique, comprenant au moins un élément semi-conducteur, qui est agencé sur un support, ainsi qu'un corps de refroidissement, qui est en contact thermique avec l'élément semi-conducteur, dans lequel le support (2) est constitué d'un matériau semi-conducteur et sert en même temps de corps de refroidissement,
**caractérisé en ce que**,
sur le support (2) lui-même, est réalisée par dopage une structure conductrice (14) avec laquelle l'au moins un élément semi-conducteur électronique (8) est mis en contact.

2. Module de puissance électronique selon la revendication 1,
**caractérisé en ce que**
le matériau semi-conducteur est du silicium.

3. Module de puissance électronique selon la revendication 1 ou 2,
**caractérisé en ce que**
plusieurs éléments semi-conducteurs (8) sont mis en contact avec la structure conductrice (14).

4. Module de puissance électronique selon l'une quelconque des revendications précédentes,
**caractérisé en ce que**
le support (8) est structuré au niveau de sa surface arrière pour former une structure de refroidissement.

5. Module de puissance électronique selon la revendication 4,
**caractérisé en ce que**
la structure de refroidissement est produite sous la forme de traverses (4) ou nervures.

6. Module de puissance électronique selon l'une quelconque des revendications précédentes,
**caractérisé en ce que**
dans le support (2), est réalisé par dopage au moins un autre élément électronique (12).
